Europäisches Patentamt

European Patent Office

Office européen des brevets

(11) Numéro de publication : **0 462 876 B1**

(12) **FASCICULE DE BREVET EUROPEEN**

(45) Date de publication du fascicule du brevet :
**30.12.92 Bulletin 92/53**

(21) Numéro de dépôt : **91401591.2**

(22) Date de dépôt : **14.06.91**

(51) Int. Cl.⁵ : **G11C 29/00**

(54) **Circuit de test de cellules mémoires électriquement programmable.**

(30) Priorité : **21.06.90 FR 9007792**

(43) Date de publication de la demande :
**27.12.91 Bulletin 91/52**

(45) Mention de la délivrance du brevet :
**30.12.92 Bulletin 92/53**

(84) Etats contractants désignés :
**DE FR GB IT**

(56) Documents cités :
**EP-A- 0 318 363**
**WO-A-81/00154**
**GB-A- 2 156 581**
**IEEE JOURNAL OF SOLID-STATE CIRCUITS**
**vol. 23, no. 5, Octobre 1988, pages 1150 - 1156;**
**R. GASTALDI ET AL: 'A 1-Mbit CMOS EPROM-**
**with Enhanced Verification '**

(73) Titulaire : **SGS-THOMSON**
**MICROELECTRONICS S.A.**
**7, Avenue Galliéni**
**F-94250 Gentilly (FR)**

(72) Inventeur : **Conan, Bertrand, Cabinet**
**BALLOT-SCHMIT**
**7, rue Le Sueur**
**F-75116 Paris (FR)**

(74) Mandataire : **Schmit, Christian Norbert Marie**
**et al**
**Cabinet Ballot-Schmit 7, rue Le Sueur**
**F-75116 Paris (FR)**

EP 0 462 876 B1

## Description

L'invention concerne le test des cellules mémoires électriquement programmables (EPROM, EEPROM).

De telles cellules se composent chacune d'un transistor à grille flottante, dont la grille de contrôle est reliée à une ligne de mot, le drain, à une ligne de bit et la source, à un potentiel de référence qui est en général la masse électrique du circuit.

L'arrangement des cellules de la mémoire est matriciel : une ligne de mot est reliée aux grilles de contrôle de tous les transistors d'une même ligne; une ligne de bit est reliée au drain de tous les transistors d'une même colonne.

Pour faciliter l'adressage, le plan mémoire est en général partagé, par exemple pour former des sous-groupes de lignes de bit. Le décodage colonne (des lignes de bit) se fait alors en deux temps : décodage d'une ligne de bit dans chaque sous-groupe et décodage du sous-groupe. Cet ensemble de sous-groupes forme un groupe qui correspond à une data ou encore un bit de données. Pour ce groupe, on aura un seul amplificateur de lecture. On pourra avoir un amplificateur d'écriture par sous-groupe, celui-ci étant sélectionné par le décodage du sous-groupe.

En pratique, les mémoires sont organisées en mots d'information d'une certaine longueur : 4, 8, 16, 32 bits de données. On a alors plusieurs groupes de lignes de bits tels que définis précédemment. Un groupe de lignes de bit correspond aux bits de poids i dans le mot d'information. Et on a donc autant de groupes que de bits dans le mot d'information.

De plus, on cherche à optimiser l'occupation de la surface du circuit semi-conducteur. Ainsi, par exemple, pour une mémoire 8 bits, c'est à dire dont un mot d'information est donné sur 8 bits de poids 0, 1,..., 7 correspondant à des broches d'entrée/sortie de données D0, D1,..., D7 de la mémoire, on définit 8 groupes de lignes de bit : un premier groupe correspondant aux bits de poids 0 (D0),..., un huitième groupe correspondant aux bits de poids 7 (D7). Et dans cet exemple, on a 8 amplificateurs de lecture, un par groupe.

On peut définir aussi par exemple deux groupes de lignes de mot : un premier groupe correspondant aux groupes 0, 1, 6 et 7 de lignes de bit D0, D1, D6 et D7, un second groupe correspondant aux groupes 2, 3, 4 et 5 de lignes de bit D2, D3, D4 et D5. Un tel choix dépend de la structure physique choisie pour le circuit et de son optimisation.

La lecture d'un mot mémoire entraînera la sélection d'une ligne de mot dans chaque groupe de ligne de mot et la sélection d'une ligne de bit dans chaque groupe de lignes de bit. Tous les bits de données du mot d'information sont alors fournis en parallèle par les amplificateurs de lecture associés aux groupes de lignes de bit.

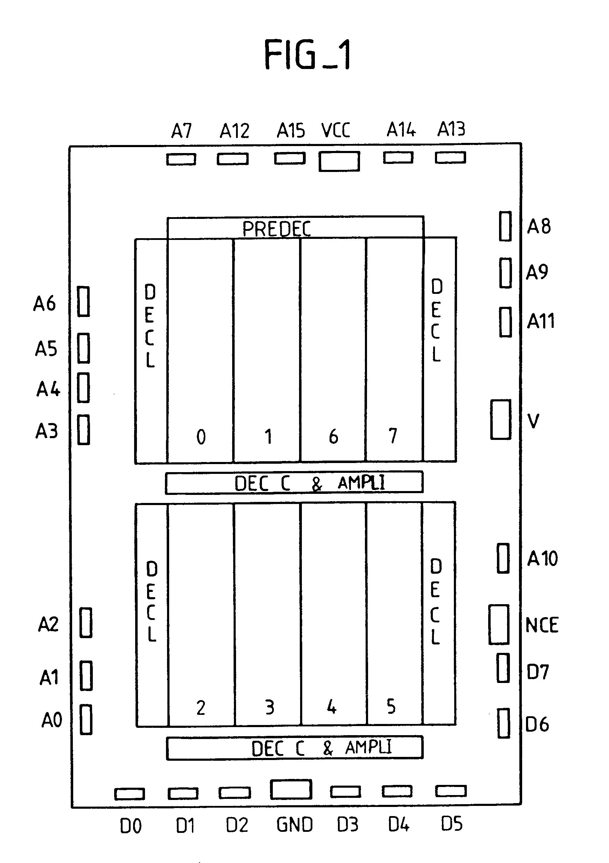

Topographiquement, comme on peut le voir sur la figure 1, un tel découpage permet une organisation en deux demi-plans, les lignes de bit étant dans l'exemple prises verticales et les lignes de mot horizontales. Le demi-plan supérieur correspond au premier groupe de lignes de mot avec les groupes 0, 1, 6 et 7 de lignes de bit. Le demi-plan inférieur correspond au second groupe de lignes de mot avec les groupes 2, 3, 4 et 5 de lignes de bit. Dans l'exemple, le second groupe de mot correspond à une simple mise en parallèle du premier. Le pré-décodeur (PREDEC) des lignes de mot est de préférence juste au-dessus et en bordure du demi-plan supérieur. Le décodeur de lignes de mot (DEC L) de chaque demi-plan est placé en bordure des côtés verticaux du demi-plan correspondant. Les décodeurs colonnes (DEC C), c'est à dire des lignes de bit, du demi-plan supérieur, et les amplificateurs de lecture et d'écriture (AMPLI) correspondants sont situés entre les 2 demi-plans. Ceux du demi-plan inférieur sont situés sous ce demi-plan inférieur, en bordure.

En périphérie du circuit mémoire, on trouve les broches d'entrée/sortie et de contrôle de la mémoire, avec les buffers associés. Ainsi en haut et sur les côtés verticaux, on trouve des broches d'entrées du bus d'adresse, dans l'exemple A0 - A15 avec les buffers d'entrées associés. Elles sont ainsi proches des différents décodeurs. On trouve aussi les broches d'alimentation Vcc, Vpp et de sélection du circuit mémoire NCE.

En bas, et un peu sur le côté droit, on a les broches d'entrée/sortie de données : D0 - D7, et la masse du circuit GND. Dans l'exemple D0 est à l'extrême gauche, D5 à l'extrême droite, D6 et D7 en bas du côté vertical droit. Les interconnexions du demi-plan supérieur avec les broches d'entrées/sorties correspondantes D0, D1, D6 et D7 sont ainsi optimisées.

Les interconnexions à réaliser sont nombreuses, entre les décodeurs, le pré-décodeur et les buffers d'entrée du bus d'adresse, les amplificateurs et les buffers d'entrée/sorties du bus de données. Ainsi, si on appelle "coeur" le plan mémoire proprement dit, "milieu" les décodeurs et amplificateurs qui donnent accès au plan mémoire et "périphérie" les buffers et les broches d'entrée/sortie du circuit, il y a entre le milieu et la périphérie , de nombreuses interconnexions à réaliser, sachant de plus que ces interconnexions ne peuvent traverser le "coeur". Ces interconnexions occupent beaucoup de place au regard du coeur, aussi cherche t-on toujours à réduire leur nombre. On cherche aussi à placer les différents circuits de manière à optimiser la longueur des interconnexions.

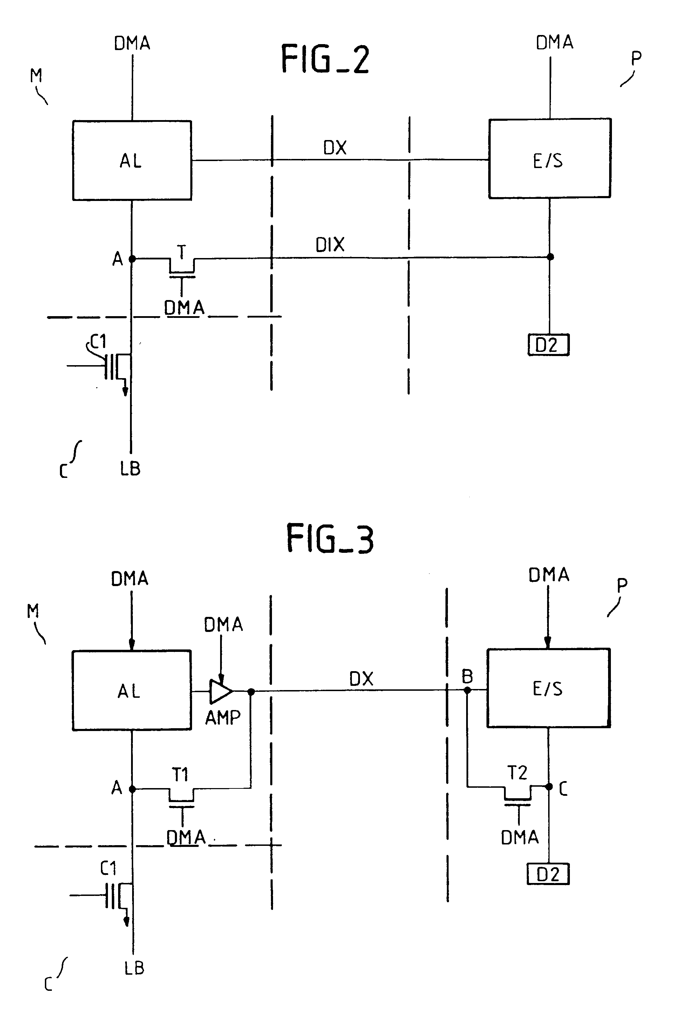

Or, pour les besoins de test des cellules mémoire électriquement programmables dont on cherche à lire, non pas le contenu binaire 0 ou 1 selon qu'elles sont programmées ou non, mais plutôt leur capacité à conduire le courant avant ou après leur programmation, on utilise des connexions supplémentaires pour pouvoir mesurer le courant qui passe dans la cellule, quand elle est accédée en lecture. Le circuit de test généralement utilisé est représenté en figure 2.

En effet, en lecture, le drain de la cellule C1 sélectionnée - c'est à dire, en fait, la ligne de bit LB correspondante - est connecté à l'entrée d'un amplificateur de lecture, qui va injecter du courant dans la cellule. Selon que le courant passe ou non dans la cellule, l'amplificateur délivre sur sa sortie un niveau logique haut ou bas. Une connexion DX relie la sortie de l'amplificateur de lecture à l'entrée du buffer d'entrée/sortie correspondant, lui-même connecté en sortie à une broche d'entrée/sortie correspondante, par exemple D2.

En test, on lit aussi la cellule, mais on veut lire le courant qui la traverse, et non le niveau logique binaire délivré en sortie de l'amplificateur de lecture. On utilise alors une connexion supplémentaire DIX qui relie la broche d'entrée/sortie D2 au drain de la cellule C1 par un transistor T utilisé en interrupteur, sa source étant connectée à la liaison DIX et son drain, au drain de la cellule. Ce transistor est topographiquement à côté de l'amplificateur, c'est à dire dans la zone milieu. Quand le circuit est en mode de test, un signal DMA met l'entrée de l'amplificateur de lecture et la sortie du buffer d'entrée/sortie en état de haute impédance, et rend le transistor/interrupteur T conducteur. Ainsi, si on impose une tension externe sur la broche D2, on peut lire le courant qui passe dans la cellule. Ce courant n'est pas perturbé par le buffer d'entrée/sortie, ni par l'amplificateur puisqu'ils ont été mis en haute impédance.

Un tel circuit de test revient à doubler les interconnexions DX : on double le nombre d'interconnexions amplificateur de lecture - buffer d'entrée/sortie. Ce qui est un inconvénient majeur comme on l'a déjà vu dans l'optimisation de la taille du circuit, puisque le nombre de connexions influe directement et de manière importante sur la taille du circuit.

L'invention a pour objet un autre circuit de test pour la lecture du courant des cellules, qui permette de réduire le nombre de connexions totales du circuit.

Dans l'invention, on remarque en effet, qu'il est moins coûteux en place d'ajouter des transistors dans le milieu ou sur la périphérie, que d'avoir à ajouter des connexions entre ces deux zones.

L'invention a donc pour objet un dispositif de test de cellules mémoire électriquement programmables d'un circuit qui comporte, pour chaque broche d'entrée/sortie de données, un buffer d'entrée/sortie associé dans une zone périphérique du circuit et un amplificateur de lecture associé dans une zone milieu du circuit, proche du plan des cellules mémoire, l'entrée du buffer d'entrée/sortie étant connectée à la sortie de l'amplificateur de lecture par une connexion DX et la sortie du buffer d'entrée/sortie étant connectée à la broche d'entrée/sortie, l'entrée de l'amplificateur de lecture étant connectée en un noeud A à une ligne de bit correspondant à une cellule sélectionnée en lecture, caractérisé en ce qu'il comporte des moyens pour court-circuiter l'entrée et la sortie de l'amplificateur de lecture en mode de test, ces moyens étant topographiquement situés dans la zone milieu du circuit et des moyens pour court-circuiter l'entrée et la sortie du buffer d'entrée/sortie en mode de test, ces moyens étant topographiquement situés dans la zone périphérique du circuit.

Les avantages et caractéristiques de l'invention sont donnés dans la description qui suit, faite à titre indicatif et nullement limitatif de l'invention et en référence aux figures annexées, dans lesquelles :

- la figure 1 est un exemple de topographie mémoire déjà décrit,
- la figure 2 est un schéma électrique d'un circuit de test connu,
- la figure 3 est un schéma électrique d'un circuit de test selon l'invention.

La figure 3 montre un circuit de test selon l'invention.

L'entrée de l'amplificateur de lecture AL est reliée par le noeud A au drain d'une cellule mémoire C1 sélectionnée ( soit, en fait, à la ligne de bit LB sélectionnée). La sortie de l'amplificateur de lecture AL est connectée à l'entrée d'un amplificateur à sortie trois états AMP (c'est à dire avec un état haute impédance). La sortie de cet amplificateur AMP est connectée à l'entrée d'un buffer d'entrée/sortie, noté E/S, par une connexion DX.

Un premier transistor T1 est utilisé en interrupteur entre le noeud A, à l'entrée de l'amplificateur de lecture, et la sortie de l'amplificateur AMP à sortie 3 états : le drain du transistor T1 est relié au point A et la source, à la sortie de l'amplificateur AMP. Il est commandé sur sa grille par un signal de mode de test DMA.

Un deuxième transistor T2 est utilisé en interrupteur entre l'entrée du buffer E/S et sa sortie : son drain est relié à l'entrée du buffer E/S au point B, et sa source, à la sortie du buffer E/S, au point C. Il est lui aussi commandé sur sa grille par le signal DMA.

La mise en état haute impédance de l'amplificateur de lecture, de l'amplificateur à sortie 3 états, et de la sortie du buffer d'entrée/sortie est commandée par le signal de mode de test DMA.

Le fonctionnement est alors le suivant : quand on passe en mode de test, le signal DMA rend conducteur les deux transistors, et met en haute impédance les sorties de l'amplificateur AMP à sortie 3 états et du buffer d'entrée/sortie. Le signal DMA met aussi l'entrée de l'amplificateur de lecture en état de haute impédance, pour l'empêcher d'injecter du courant dans la cellule, ce qui perturberait le test.

En fait, l'amplificateur de lecture comporte classiquement un amplificateur de sortie non représenté, dont on pourrait modifier la structure dans l'invention, pour pouvoir le mettre en état de haute impédance, sur commande DMA. Dans l'exemple, on a préféré ajouter sur la sortie de l'amplificateur de lecture, un amplificateur à sortie 3 états AMP.

En mode de test, si on applique une tension sur la broche D2, un courant va circuler dans la cellule sélectionnée et passer dans la liaison DX, l'amplificateur de lecture avec l'amplificateur AMP et le buffer d'entrée/sortie étant chacun court-circuités. On peut mesurer le courant sur la broche D2.

Le premier transistor T1 et l'amplificateur AMP à sortie 3 états sont réalisés dans la zone milieu M, près de l'amplificateur de lecture.

Le deuxième transistor T2 est lui réalisé dans la zone périphérique P, près du buffer E/S.

On rajoute ainsi de la circuiterie supplémentaire, mais en compensation, il n'y a plus qu'une seule liaison, la liaison DX, opérationnelle : la liaison DIX de la figure 2 est supprimée.

Ainsi, en rajoutant autant de circuiteries supplémentaires selon l'invention, dans les zones milieu et périphérique, qu'il y a de broches d'entrée/sortie Di, on supprime autant de connexions inter-zones dédiées au test. Et finalement, on peut réduire la surface du circuit mémoire.

De plus, comme il y a moins de connexions la fiabilité du circuit augmente.

## Revendications

1. Circuit mémoire comprenant un dispositif de test de cellules mémoire électriquement programmables du circuit mémoire qui comporte, pour chaque broche d'entrée/sortie de données (D2), un buffer d'entrée/sortie (E/S) associé dans une zone périphérique (P) du circuit mémoire et un amplificateur de lecture (AL) associé dans une zone milieu (M) du circuit, mémoire proche du plan (C) des cellules mémoire, l'entrée du buffer d'entrée/sortie étant connectée à la sortie de l'amplificateur de lecture par une connexion (DX) et la sortie du buffer d'entrée/sortie étant connectée à la broche d'entrée/sortie, l'entrée de l'amplificateur de lecture étant connectée en un noeud (A) à une ligne de bit (LB) correspondant à une cellule (C1) sélectionnée en lecture, caractérisé en ce que le dispositif de test comporte des moyens (T1, AMP) pour court-circuiter l'entrée et la sortie de l'amplificateur de lecture (AL) en mode de test, ces moyens étant topographiquement situés dans la zone milieu (M) du circuit mémoire et des moyens (T2) pour court-circuiter l'entrée et la sortie du buffer d'entrée/sortie (E/S) en mode de test, ces moyens étant topographiquement situés dans la zone périphérique (P) du circuit mémoire.

2. Circuit mémoire selon la revendication 1, caractérisé en ce que les moyens pour court-circuiter l'entrée et la sortie de l'amplificateur de lecture comportent un amplificateur à sortie 3 états (AMP) connecté entre la sortie de l'amplificateur de lecture (AL) et la connexion (DX) et dont la mise en état de haute impédance est commandée par un signal de mode de test (DMA) et un premier transistor (T1) dont le drain est connecté au noeud (A) et la source à la sortie de l'amplificateur à sortie 3 états (AMP), sa grille étant commandée par le signal de mode de test (DMA).

3. Circuit mémoire selon la revendication 1 ou 2, caractérisé en ce que les moyens pour court-circuiter le buffer d'entrée/sortie (E/S) comportent un deuxième transistor (T2) dont le drain est connecté à l'entrée du buffer d'entrée/sortie et la source à la sortie du buffer d'entrée/sortie, sa grille étant commandée par un signal de mode de test (DMA) qui commande aussi la mise en état haute impédance du buffer d'entrée/sortie.

## Patentansprüche

1. Speicherschaltung mit einer Einrichtung zur Prüfung von elektrisch programmierbaren Speicherzellen der Speicherschaltung, die für jeden Daten-Eingabe/Ausgabe-Anschluß (D2) in einem peripheren Bereich (P) der Speicherschaltung einen zugeordneten Eingabe/Ausgabe-Puffer (E/S) und in einem mittleren Bereich (M) der Speicherschaltung nahe der Speicherzellenanordnung (C) einen zugeordneten Leseverstärker (AL) umfaßt, wobei der Eingang des Eingabe/Ausgabe-Puffers über eine Verbindung (DX) mit dem Ausgang des Leseverstärkers, der Ausgang des Eingabe/Ausgabe-Puffers mit dem Eingabe/Ausgabe-Anschluß und der Eingang des Leseverstärkers an einem Knotenpunkt (A) mit einer Bitleitung (LB) verbunden ist, die einer beim Lesen ausgewählten Zelle (C1) entspricht, dadurch gekennzeichnet, daß die Prüfeinrichtung Mittel (T1, AMP) umfaßt, um den Eingang und den Ausgang des Leseverstärkers (AL) im Prüfmodus kurzzuschließen, wobei diese Mittel topographisch in dem mittleren Bereich (M) der Speicherschaltung angeordnet sind, sowie Mittel (T2) zum Kurzschließen des Eingangs und des Ausgangs des Eingabe/Ausgabe-Puffers (E/S) im Prüfmodus, wobei diese Mittel topographisch in dem peripheren Bereich (P) der Speicherschaltung angeordnet sind.

2. Speicherschaltung nach Anspruch 1, dadurch gekennzeichnet, daß die Mittel zum Kurzschließen des Eingangs und des Ausgangs des Leseverstärkers einen Verstärker (AMP) mit Dreizustands-Ausgang umfassen, der zwischen den Ausgang des Leseverstärkers (AL) und die Verbindung (DX) geschaltet ist und der durch die Ansteuerung über ein Prüfmodussignal (DMA) in den hochohmigen Zustand versetzbar ist, sowie einen ersten Transistor (T1) umfassen, dessen Drain-Anschluß mit dem Knotenpunkt (A) und dessen Source-Anschluß mit dem Ausgang des Verstärkers (AMP) mit Drei-Zustands-Ausgang verbunden ist, wobei dessen Gate-Anschluß durch das Prüfmodussignal (DMA) steuerbar ist.

3. Speicherschaltung nach Anspruch 1 oder 2, dadurch gekennzeichnet, daß die Mittel zum Kurzschließen des Eingabe/Ausgabe-Puffers (E/S) einen zweiten Transistor (T2) umfassen, dessen Drain-Anschluß mit dem Eingang des Eingabe/Ausgabe-Puffers und dessen Source-Anschluß mit dem Ausgang des Eingabe/Ausgabe-Puffers verbunden ist und dessen Gate-Anschluß über ein Prüfmodussignal steuerbar ist, das auch das Einstellen des hochohmigen Zustands des Eingabe/Ausgabe-Puffers steuert.

**Claims**

1. A memory circuit comprising a device for electrically testing electrically programmable memory cells of a memory circuit which includes, for each data input/output pin (D2), an associated input/output buffer (E/S) in a peripheral zone (P) of the memory circuit and an associated read amplifier (AL) in a middle zone (M) of the memory circuit, close to the array (C) of memory cells, the input of the input/output buffer being connected to the output of the read amplifier by a connection (DX) and the output of the input/output buffer being connected to the input/output pin, the input of the read amplifier being connected at a node (A) to a bit line (LB) corresponding to a selected cell (C1) in reading mode, characterized in that the said device comprises means (T1, AMP) for short-circuiting the input and the output of the read amplifier (AL) in testing mode, these means being topographically located in the middle zone (M) of the memory circuit, and means (T2) for short-circuiting the input and the output of the input/output buffer (E/S) in testing mode, these means being topographically located in the peripheral zone (P) of the memory circuit.

2. A memory circuit according to claim 1, characterized in that the means for short-circuiting the input and the output of the read amplifier comprise a three-state-output amplifier (AMP), connected between the output of the read amplifier (AL) and the connection (DX), the setting of the said three-state-output amplifier in a state of high impedance beina controlled by a test mode signal (DMA), and a first transistor (T1), the drain of which is connected to the node (A) and the source of which is connected to the output of the three-state-output amplifier (AMP), its gate being controlled by the test mode signal (DMA).

3. A memory circuit according to claim 1 or claim 2, characterized in that the means for short-circuiting the input/output buffer (E/S) comprise a second transistor (T2), the drain of which is connected to the input of the input/output buffer and the source of which is connected to the output of the input/output buffer, its gate being controlled by a test mode signal (DMA) which also controls the setting of the input/output buffer in a state of high impedance.

# FIG_1

# FIG_2

# FIG_3